# EUROPEAN PATENT SPECIFICATION

(11) **EP 1 806 960 B1**
(45) Date of publication and mention of the grant of the patent: **24.10.2012**
(21) Application number: 06025709.4
(22) Date of filing: 12.12.2006
(51) Int. Cl.: H05K 5/06, H05K 7/20

(54) **Electronic device**
Elektronisches Gerät
Dispositif électronique

(30) Priority: 06.01.2006 JP 2006001826
(43) Date of publication of application: 11.07.2007
(73) Proprietor: DENSO CORPORATION, Kariya-city, Aichi-pref. 448-8661 (JP)
(72) Inventor: Shinoda, Takuya, Kariya-city, Aichi-pref., 448-8661 (JP)
(74) Representative: Winter, Brandl, Fürniss, Hübner, Röss, Kaiser, Polte - Partnerschaft

(56) References cited:
- DE-C1- 10 051 945
- JP-A- 2001 237 577
- JP-A- 2002 216 886
- US-A1- 2004 095 732

## Description

The present invention relates to an electronic device, which is provided with a waterproof structure of a case by using a sealing material, in a state where a circuit substrate is housed in the case.

JP-A-2003-289191 discloses a heat radiating structure of an electronic device mounted in a vehicle and the like, in which a circuit substrate having electronic components mounted on a printed circuit board is thermally connected to a case for housing the printed circuit board via a thermally conductive material having flexibility so as to utilize the case as a heat radiating plate. When the thermally conductive material having the flexibility is arranged between the case and the printed circuit board or between the case and the electronic components, heat radiation can be improved.

Moreover, in JP-A-2005-93602 is disclosed an electronic device constructed in such a way that a sealing material is interposed between a container for housing electronic circuit components and a cover. When the container and the cover are sealed by the use of the sealing material in this manner, a space in which the electronic circuit components are housed can be brought to a waterproof space.

If the electronic components are mounted on a peripheral portion of the printed circuit board so as to improve heat radiation and the sealing material shown in JP-A-2005-93602 is simply applied so as to provide waterpoofness in the structure of JP-A-2003-289191, for example, it can be thought that the sealing material having fluidity in a state before being cured flows into the inner space of the case and may contact the thermally conductive material. When the sealing material contacts the thermally conductive material in this manner, there is a possibility to cause troubles that the sealing material cannot exert desired sealing performance and that the thermally conductive material cannot exert heat radiation. To overcome this problem, a groove may be formed as a reservoir of the sealing material in the case. In contrast, a fitting portion (for example, bracket) for fitting the case is fixed usually to the outer peripheral surface of the case corresponding to the peripheral portion of the circuit board. Alternatively, the fitting portion is constructed as a part of the case. Thus, when the electronic components are mounted on the peripheral portion of the printed circuit board, a heat radiation path to the fitting portion can be shortened, so heat radiation can be improved.

JP-A-2002-216886 discloses an electronic device comprising a case for housing a printed circuit board with a case member and a base member, a sealing material interposed between the case member and the base member, and a thermally conductive material interposed between the base member and the printed circuit board. The sealing material is provided in a groove of the base member.

JP-A-2001-237577 also discloses a case for housing a printed circuit board with a case member and a base member, a sealing material interposed between the case member and the base member, wherein a projection portion protrudes from the base member into the sealed space.

Generally, a die casting method (casting process) or press working method (plastic working process) is employed for forming a case constructing an electronic device. In the die casting method, a metallic material such as aluminum or a resin material is poured into a die in a melted state to form a case member, thereby it is easy to respond to a complicated shape. However, there is a problem that a forming apparatus is complicated and that manufacturing cost is increased.

In contrast to this, in the press working method, as compared with the die casting method, a forming apparatus can be made simple and manufacturing cost can be decreased. However, since pressure is applied to a raw material to deform the material, it is difficult to form a complicated shape. That is, it is difficult to form a narrow and deep groove (i.e., a groove having a small radius) as a groove in which a sealing material is collected. For example, when a narrow and shallow groove is formed, the amount of the sealing material to be collected in the groove is small, so there is a possibility that the sealing material will climb over the groove to contact the thermally conductive material. Moreover, when a wide groove is formed, it is possible to prevent the sealing material from climbing over the groove to contact the thermal conductive material, but a position where the electronic components are mounted on the printed circuit board is far away from the peripheral portion by the width of the groove, which results in decreasing heat radiation.

In view of the above-mentioned problems, an object of the present invention is to provide an electronic device capable of securing sealing performance and heat radiation performance. It is another object of the present invention to provide an electronic device capable of securing sealing performance and heat radiation performance while reducing manufacturing cost.

According to an aspect of the present invention, an electronic device with the features according to claim 1 is provided by which the sealing performance and heat radiation performance can be secured.

In addition, at least one of the case member (20) and the base member (30) on a side where the thermally conductive material (50) is arranged with respect to the printed circuit board (11) can be formed by pressing. Thus, even when the projection portion (35) is integrally constructed as a part of the case by the pressing, it is possible to reduce manufacturing cost as compared with a case of using a die casting method such as die casting or resin injection molding.

Moreover, the projection portion (35, 60) is formed between the first portion where the thermally conductive material (50) is arranged and the second portion where the sealing material (40) is arranged. lf a groove portion is provided for separating the sealing material from the thermally conductive material, a damming capacity for separating the sealing material and the thermal conductive material is determined by the volume of the groove. By contrast, when the projection portion (35, 60) is provided for separating the sealing material (40) from the thermally conductive material (50), a damming capacity is determined by the height (h1) of the projection portion and the area of a region (case) lower than the projection portion (35, 60) connecting with the projection portion (35, 60). That is, even if the damming capacity for the sealing material (40) is the same, the height of the projection portion (35, 60) can be made shorter (lower) than the depth of the groove portion with respect to the first portion where the thermal conductive material (50) is arranged, so the width of the projection portion (35, 60) can be made narrower than the width of the groove portion. Thus, it is possible to effectively prevent the contact between the sealing material (40) and the thermal conductive material (50) and at the same time to arrange the electronic components (12a) as closer to the peripheral portion of the printed circuit board (11) as possible. Therefore, it is possible to effectively secure sealing performance and heat radiation performance.

The projection portion may be a partition part (60) that is fixed to the case (20, 30) after being formed separately from the case (20, 30). ln this case, the shape of the partition part (60) can be freely set.

The projection portion (35, 60) may be formed only between the first portion and the second portion, which are close and opposite to each other, or may be formed in an annular shape along at least a portion of an outer peripheral end of the first portion where the thermally conductive material (50) is arranged. Furthermore, the projection portion (35, 60) may have a height that is set to prevent the projection portion (35, 60) from contacting a surface of the printed circuit board (11). Alternatively, the projection portion (35, 60) may have a height that is set nearly equal to a clearance between the first portion where the thermally conductive material (50) is arranged and a surface of the printed circuit board (11) opposed to the thermally conductive material (50). ln this case, the printed circuit board (11) has a region without providing an electric connection function, as a contact portion where the printed circuit board (11) contacts the projection portion (35, 60).

Furthermore, the printed circuit board (11) may be placed on the case member (20) or the base member (30) to form a clearance for sealing, between an end surface of the printed circuit board (11), and the case member (20) or the base member (30) opposed to the end surface. ln this case, the sealing material (40) is arranged in the clearance for sealing.

ln the electronic device, the thermally conductive material (50) may be made of heat radiating gel or heat radiating grease.

Additional objects and advantages of the present invention will be more readily apparent from the following detailed description of preferred embodiments when taken together with the accompanying drawings.
FIG. 1 is a perspective view to show a general construction of an electronic device according to a first embodiment of the present invention.
FIG. 2A is an enlarged sectional view of a projection portion of the electronic device, and FIG. 2B is a plan view of a base member of the electronic device according to the first embodiment.
FIG. 3A is a sectional view of an electronic device according to a second embodiment of the present invention and FIG. 3B is a plan view of a base member of the electronic device in FIG. 3A.
FIG. 4 is a plan view showing another example of a base member of the electronic device according to the second embodiment.
FIG. 5 is a sectional view to show a general construction of an electronic device according to a third embodiment of the present invention.
FIG. 6 is a sectional view to show a general construction of an electronic device according to a fourth embodiment of the present invention.

Hereinafter, the preferred embodiments of the present invention will be described with reference to the drawings.

### (First Embodiment)

An electronic device according to this embodiment has a waterproof structure and is suitably applicable to an electronic device (for example, engine ECU (Electronic Control Unit)) arranged outside a passenger compartment, for example, in an engine room, of the vehicle.

An electronic device 100 includes: a circuit substrate 10; a case member 20 and a base member 30 constructing a case for housing therein the circuit substrate 10; a sealing material 40 that brings the inner space formed by the case member 20 and the base member 30, to a waterproof space; and a thermally conductive material 50 for improving heat radiation generated from the circuit substrate 10.

In the circuit substrate 10, electronic components 12 such as a microcomputer, resistors or capacitors are mounted on a printed circuit board 11 having wiring patterns (not shown) and via holes for connecting the wiring patterns formed thereon. A material constructing the printed circuit board 11 is not limited to a special material. Publicly known materials such as thermoplastic resin, thermosetting resin, ceramics, or composite of glass (for example, glass cloth) and resin can be employed as the material. In this embodiment, a multi-layer board in which wiring patterns are arranged in many layers on epoxy resin including glass cloth can be used.

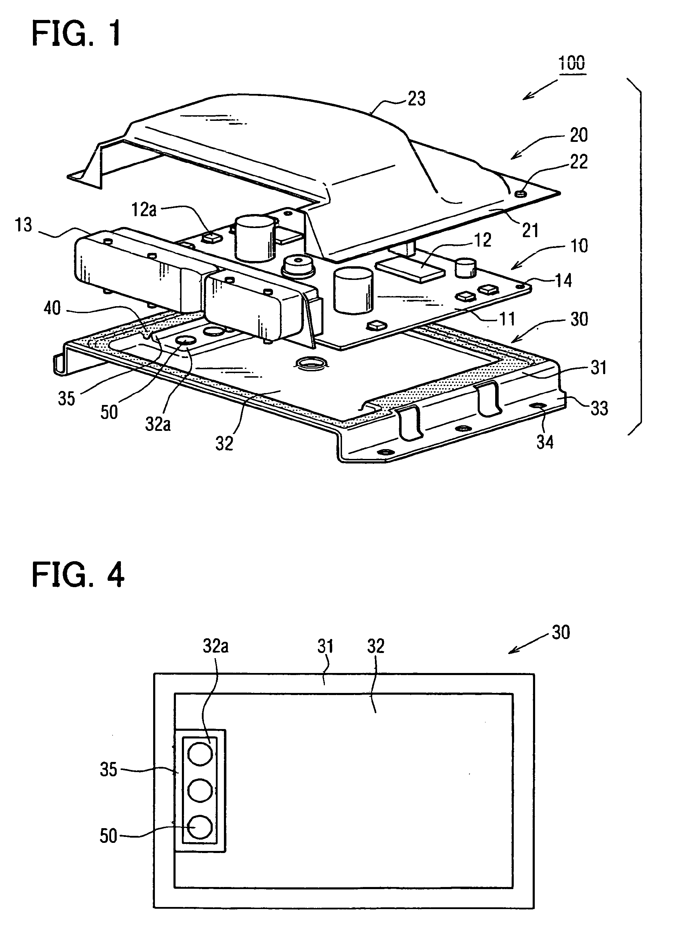

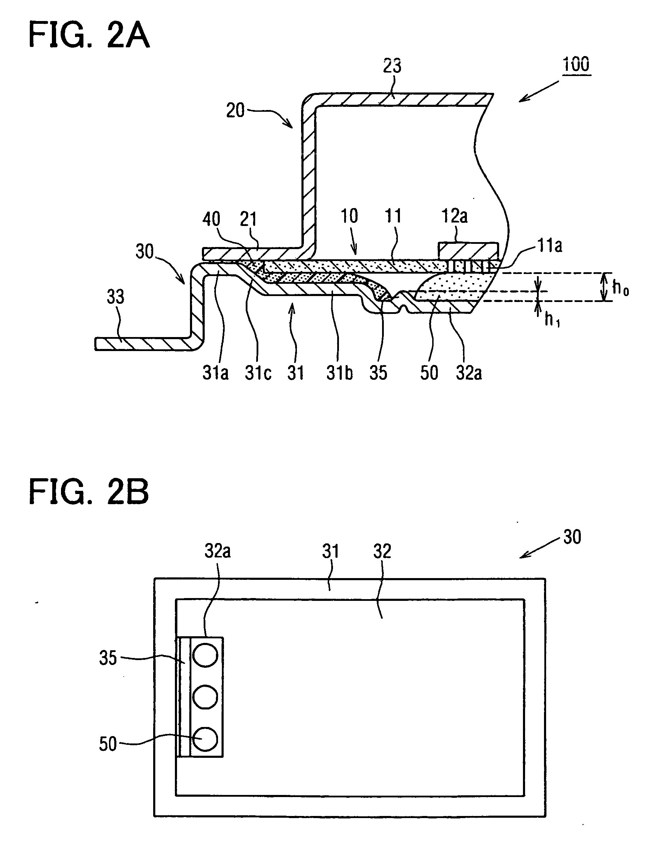

Moreover, the electronic components 12 include a heating element 12a, for example, a power transistor that operates to produce heat excessively. This heating element 12a corresponds to an electronic component (heat generating member) for generating heat when being operated. The heating element 12a, as shown in FIG. 1 and FIG. 2A, is mounted on a peripheral portion of the printed circuit board 11 to shorten a heat radiation path. The reference sign 13 denotes a connector as an external connecting terminal mounted on the printed circuit board 11, and the connector 13 is constructed so as to expose its one end to the outside of the case in a state in which the electronic device 100 is constructed. The reference sign 14 denotes a positioning depression formed at a corner of the printed circuit board 11 to position the case (i.e., case member 20). Moreover, the reference sign 11 a shown in FIG. 2A denotes via holes. The via holes 11a are formed in the printed circuit board 11 at positions corresponding to the heating element 12a to improve heat radiation from the heating element 12a to the case (i.e., base member 30).

The case member 20 constructing the case is formed in the shape of a deep box one side of which is open by pressing. A material for forming the case member 20 is not limited to aluminum but a material to be formed by pressing can be employed as appropriate according to use. The reference sign 21 denotes a fixing portion opposing to the base member 30 and contacting the sealing material 30. On the fixing portion 21 is formed a positioning projection portion 22 corresponding to the positioning depression 14 formed in the printed circuit board 11. Moreover, the reference sign 23 denotes a space forming portion that is bent with respect to the fixing portion 21 for forming an inner space of the case. Here, although not shown, the sealing material 40 is arranged on a portion contacting the connector 13.

The base member 30 constructing the case is also formed into the shape of a shallow box to close the open face of the case member 20 by pressing. This base member 30 corresponds to a case member (cover member) for covering the open face of the case member 20. Material for forming the base member 30 is not limited to aluminum but other material to be formed by pressing can be employed as appropriate according to the purpose of use. The reference sign 31 denotes a fixing portion that is nearly parallel to the fixing portion 21 of the case member 20. The sealing material 40 is arranged on at least a portion of the fixing portion 31. The fixing portion 31 includes a narrow portion 31 a having a narrow or nearly zero clearance between the narrow portion 31a and the fixing portion 21 of the case member 20; a wide portion 31 b having relatively a wide clearance between the wide portion 31 b and the fixing portion 21; and a connecting portion 31 c bent for connecting the narrow portion 31 a to the wide portion 31 b. This wide portion 31 b is a flat portion approximately parallel to the fixing portion 21, and the narrow portion 31 a is also a flat portion approximately parallel to the fixing portion 21. The connecting portion 31 c is bent from the narrow portion 31 a to the wide portion 31 b so as to form a space with the fixing portion 21. The sealing material 40 is not interposed between the fixing portion 21 and the narrow portion 31 a or, even if interposed, the sealing material 40 is thin therebetween. The sealing material 40 and the printed circuit board 11 are interposed in the clearance formed by the connecting portion 31 c, the wide portion 31 b and the fixing portion 21, as shown in FIG. 2A.

The reference sign 32 denotes a space forming portion that is bent with respect to the fixing portion 31 of the base member 30 for forming the inner space of the case. In a portion of the space forming portion 32, a raised region 32a raised from the other part of the space forming portion 32 is formed as shown in FIG. 1. A clearance between the raised region 32a and the printed circuit board 11 is narrower than a clearance between the other space forming portion 32 and the printed circuit board 11, and is wider than a clearance between the wide portion 31 b and the printed circuit board 11, in a state in which the electronic device 100 is formed. The thermally conductive material 50 is arranged on this raised region 32a at a position corresponding to the heating element 12a so as to improve heat radiation. This raised region 32a is used as a bottom portion of the thermally conductive material 50. The reference sign 33 denotes a fitting portion (mounting portion) that is bent with respect to the fixing portion 31 to the outer side opposite to the space forming portion 32. The fitting portion 33 has screw holes 34 for fixing screws. That is, in this embodiment, a bracket to be fitted the other part (i.e., object to be fitted) is constructed as a portion of the base member 30, whereby a heat radiation path is constructed so as to dissipate heat transferred to the case (base member 30) from the circuit substrate 10 via the thermally conductive material 50 to the other part. Thus, as described above, it is possible to shorten the heat radiation path to improve heat radiation by mounting the heating element 12a on the peripheral portion of the printed circuit board 11.

Further, a projection portion 35 projects inward with respect to a portion of the raised region 32a, where the thermally conductive material 50 is arranged. In this embodiment, the projection portion 35 is provided at an end portion of the raised region 32a, and is formed integrally with the base member 30 as a portion of the base member 30 by pressing. That is, as shown in FIGS. 1 and 2A, the projecting portion 35 is located between the portion (i.e., first portion, arrangement portion) where the thermally conductive material 50 is arranged and the fixing portion 31 (i.e., second portion) where the sealing material 40 is arranged. Thus, this projection portion 35 can prevent the sealing material 40 before being hardened from flowing to and contacting the thermally conductive material 50. Furthermore, the projection portion 35 prevents the thermally conductive material 50 from being moved by applied vibrations or the like to contact the sealing material 40. In this manner, the projection portion 35 functions as a dam with respect to the sealing material 40 and the thermally conductive material 50. Therefore, the sealing material 40 can be effectively partitioned from the thermally conductive material 50 by the projection portion 35.

It is possible to prevent the contact between the sealing material 40 and the thermally conductive material 50 also by forming a groove portion in the base member 30. In the case of the projection portion 35, however, a damming capacity with respect to the sealing material 40 and the thermally conductive material 50 is determined by a projecting height h₁ and the area of a region connecting with the projection portion 35 and lower than the projection portion 35. Here, the region is a collection region where the sealing material 40 collects, and corresponds to a part of the raised region 32a in this embodiment. By contrast, in the case of the groove portion, a damming capacity with respect to the sealing material 40 and the thermally conductive material 50 is determined by the volume of the groove portion. That is, even if the damming capacity is the same, in the case of the projection portion 35, the height of the projection portion 35 can be shorter (lower) than the depth of the groove portion with respect to the raised region 32a, thereby the width of the projection portion 35 can be narrower than the width of the groove portion. Thus, it is possible to form the projection portion 35 even by press working and to arrange the heating element 12a as close to the peripheral portion of the printed circuit board 11 as possible while preventing the contact between the sealing material 40 and the thermally conductive material 50. Hence, it is possible to secure sealing performance and heat radiation performance in the electronic device.

Moreover, in this embodiment, as shown in FIG. 2A, the height h₁ of the projection portion 35 is made shorter than a clearance dimension h₀ between the raised region 32a and the surface of the printed circuit board 11 opposed to the raised region 32a. Therefore, the projection portion 35 is prevented from contacting the surface of the printed circuit board 11. Thus, even if the case (e.g., base member 30) is formed of an electrically conductive material, it is possible to prevent the projection portion 35 from becoming shorted to the printed circuit board 11.

Moreover, as shown in FIG. 2B, the projection portion 35 is formed only at a position close to the thermally conductive material 50, between the portion where the thermally conductive material 50 is arranged, and the fixing portion 31. That is, the projection portion 35 is formed only in an area in which the portion, where the thermally conductive material 50 is arranged, is close and opposite to the fixing portion 31. Thus, it is possible to make distortion created in the case (base member 30) by press working as small as possible, thereby reducing a forming load by press working.

A material having an elastic force and an adhesive force and capable of being interposed between the case member 20 and the base member 30 and bringing a space constructed by the case member 20 and the base member 30 to a waterproof space (producing a sealing effect) can be employed as the sealing material 40. This embodiment uses a silicon adhesive cured by moisture and having 150 to 200 Pa·s in a not-yet-cured state. In addition to this, for example, a material disclosed in JP-A-2005-93602 can be employed as the sealing material 40.

The thermally conductive material 50 is arranged between the case and the heating element 12a or between the case and the back of a portion where the heating element 12a is mounted in the printed circuit board 11 in correspondence with the heating element 12a so as to dissipate heat produced by the heating element 12a to the outside via the case (base member 30). As the thermally conductive material 50 can be employed a thermally conductive material having flexibility (low viscoelasticity), for example, as disclosed in JP-A-2003-289191. When the thermally conductive material 50 having flexibility is arranged in the above-mentioned portion, it is possible to improve heat radiation performance. Moreover, since the thermally conductive material 50 has flexibility, even if the clearance between the case and the printed circuit board 11 or the case and the heating element 12a is not constant, it is possible to prevent stress from being concentrated onto a local portion of the heating element 12a to break it. This embodiment employs a silicon gel having 600 to 1000 Pa·s and is constructed in such a way that the thermally conductive material 50 is interposed between the back of the portion where the heating element 12a is mounted in the printed circuit board 11, and the base member 30 (i.e., raised region 32a).

Next, one example of an assembling method of the electronic device 100 will be described. The case member 20 and the base member 30 for constructing the case, and the circuit substrate 10, which have been described above, are prepared. The sealing material 40 is applied to a portion of the case member 20, connected to the connector 13, and then the printing board 11 is combined with the case member 20 in such a way that the positioning projection portion 22 of the case member 20 is inserted into the positioning depression 14 of the printed circuit board 11. Thereafter, the thermally conductive material 50 is arranged on the raised region 32a of the base member 30. Then, the above-mentioned circuit substrate 10 and case member 20, which have been temporarily fitted to each other, are pressed onto the sealing material 40 and placed on the base member 30 in such a way that the circuit substrate 10 is arranged on the wide portion 31 b of the fixing portion 31 with respect to the base member 30 having the sealing material 40 applied to the fixing portion 31. At this time, the sealing material 40 is secured in a clearance formed by the end surface of the printed circuit board 11, the fixing portion 21 of the case member 20 and the fixing portion 31 of the base member 30 (connecting portion 31c). Thus, sealing performance and connection reliability can be secured in the electronic device 100, by the sealing material 40.

Moreover, when the circuit substrate 10 and case member 20 are placed on the sealing material 40, the sealing material 40 pressed by the circuit substrate 10 and case member 20 is moved toward the raised region 32a via a clearance between the wide portion 31 b of the fixing portion 31 and the printed circuit board 11 opposed to the wide portion 31 b. As shown in FIG. 2A, the raised region 32a is located at a position lower than the fixing portion 31. However, the sealing material 40 is dammed and partitioned by the projection portion 35, whereby the sealing material 40 is prevented from contacting the thermally conductive material 50. In this state, the sealing material 40 is cured, whereby the case member 20 and the connector 13, the connector 13 and the base member 30, and the base member 30 and the case member 20 are water-tightly connected to each other by the sealing material 40. With this, in the electronic device 100, the circuit substrate 10 is housed in a waterproof state in a space constructed of the connector 13, the case member 20 and the base member 30.

According to the electronic device 100 of this embodiment, the constituent elements (the case member 20 and the base member 30) of the case can be formed by press working (pressing). Thus, it is possible to reduce manufacturing cost as compared with a die casting method such as die casting or resin injection molding. Here, even if only the constituent element of the case on the side on which the thermally conductive material 50 is arranged with respect to the printed circuit board 11 (i.e., base member 30 in the embodiment) is formed by press working, it is possible to effectively reduce manufacturing cost.

Moreover, in this embodiment, a dam for preventing the contact between the sealing material 40 and the thermally conductive material 50 is constructed of the projection portion 35. The height of the projection portion 35 can be made shorter (lower) than the depth of the groove portion with respect to the raised region 32a, in order to produce a predetermined damming capacity relative to the sealing material 40. Thus, when the projection portion 35 is provided for obtaining the predetermined damming capacity, it is possible to make the width of the projection portion 35 as narrow as possible by press working. Thus, the heating element 12a can be arranged as close to the peripheral portion of the printed circuit board 11 as possible while preventing the contact between the sealing material 40 and the thermally conductive material 50. As a result, it is possible to secure sealing performance and heat radiation performance in the electronic device 100.

Moreover, in this embodiment, the projection portion 35 is constructed as a portion of the base member 30. Thus, it is possible to reduce the number of parts in the electronic device 100.

Further, in this embodiment, the sealing material 40 is secured in the clearance formed by the surface of the end portion of the printed circuit board 11, the fixing portion 21 of the case member 20, and the fixing portion 31 (connecting portion 31c) of the base member 30. Thus, it is possible to secure sealing performance and heat radiation performance by a simple construction. In this embodiment, the sealing material 40 is interposed between the wide portion 31 b of the fixing portion 31 and the printed circuit board 11, so it is possible to improve connection reliability therebetween.

Still further, in this embodiment, the distance to be flowed by the sealing material 40 to the projection portion 35 is secured by the wide portion 31 b. That is, when the case member 20 is placed on the base member 30, the sealing material 40 is arranged (elongated) inside the end surface of the printed circuit board 11 while packing a space (flow passage) formed by the wide portion 31 b and the printed circuit board 11 by its fluidity (viscosity). Thus, it is possible to improve sealing performance (waterproofness) and at the same time to effectively prevent the contact between the sealing material 40 and the thermally conductive material 50.

In this embodiment has been described an example in which, in order to shorten the heat radiation path, the raised region 32a which is closer to the printed circuit board 11 than the other space forming portion 32 is formed in correspondence with the region where the heating element 12a is formed, and in which the thermally conductive material 50 is arranged in this raised portion 32a. However, it is also possible to employ a construction in which the raised region 32a is not formed in the space forming portion 32.

Moreover, in this embodiment has been described an example in which the thermally conductive materials 50 are arranged on the raised region 32a at three positions as shown in FIG. 2B. However, the number of the arrangement portions where the thermally conductive material 50 is arranged is not limited to the above-mentioned example. One thermally conductive material 50 may be arranged for one heating element 12a, and one thermally conductive material 50 may be arranged for a plurality of heating elements 12a. For example, the thermally conductive materials 50 for different positions of the heating elements 12a may be continuously formed or may be formed separately from each other.

Further, in this embodiment has been described an example in which the portions of the three thermally conductive materials 50 and a portion where the sealing material 40 close to the materials 50 is arranged are partitioned by one straightly elongated projection portion 35, as shown in FIG. 2B. However, separated projection portions 35 may be formed respectively between the three portions where three thermally conductive materials 50 are arranged and the portion where the sealing material 40 is arranged.

Still further, another element may be arranged between the printed circuit board 11 and the heating element 12a on the printed circuit board 11. Even in this case, as described in this embodiment, it is preferable from the viewpoint of heat radiation that the heating element 12a is arranged on the outermost periphery of the printed circuit board 11.

### (Second Embodiment)

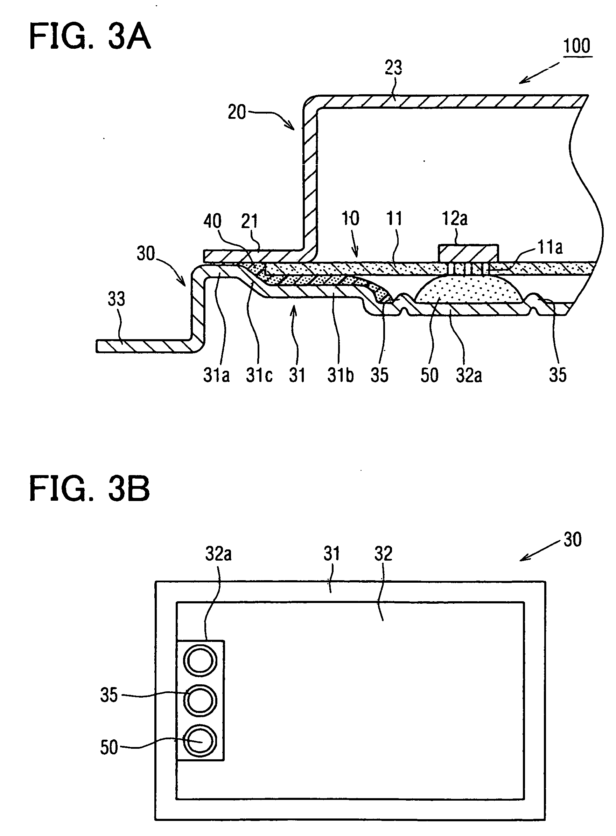

Next, a second embodiment of the present invention will be described with reference to FIGs. 3A and 3B.

An electronic device 100 according to the second embodiment has portions common to the electronic device 100 according to the first embodiment, so hereinafter the detailed descriptions of the common portions will be omitted and descriptions will be provided with emphasis on of different portions.

As shown in FIGs. 3A and 3B, in the electronic device 100 according to this embodiment, each of projection portions 35 is formed in an annular shape along the outer peripheral end of a portion where the thermally conductive material 50 is arranged. In this embodiment, in the planar direction, the thermally conductive material 50 is arranged in a circular shape and the projection portion 35 is formed in an annular shape around the thermally conductive material 50.

In this manner, according to the electronic device 100 relating to this embodiment, in addition to the effect of the first embodiment, it is possible to prevent the contact between the sealing material 40 and the thermally conductive material 50 with more reliability. Moreover, it is possible to prevent the movement of the thermally conductive material 50 by the annular projection portion 35. That is, even if vibrations and the like are applied to the electronic device 100, it is possible to prevent a movement of the thermally conductive material 50. Moreover, as described in the first embodiment, when the thermally conductive material 50 is arranged first on the base member 30 at the time of assembling, only by arranging the thermally conductive material 50 in a region defined by the projection portion 35, it is possible to accurately arrange the thermally conductive material 50 at a desired position. That is, the thermally conductive material 50 can be easily positioned at a predetermined position.

In this embodiment, the projection portion 35 is formed in an annular shape along the whole outer peripheral end of the portion where the thermally conductive material 50 is arranged. However, the projection portion 35 may be formed approximately in an annular shape along at least a portion of the outer peripheral end of the arrangement portion where the thermally conductive material 50 is arranged. Even in this case, the thermally conductive material 50 can be easily positioned along the partial annular shape of the projection portion. Furthermore, because the radius of the annular shape of the projection portion 35 can be large, the projection portion 35 can be easily formed by press working. Moreover, the projection portion 35 may be formed in an annular shape or other shape so as to surround the arrangement portion where the thermally conductive material 50 is arranged. Furthermore, as shown in FIG. 4, the projection portion 35 can be formed so as to totally surround all the separated arrangement portions where the thermally conductive materials 50 are arranged.

### (Third Embodiment)

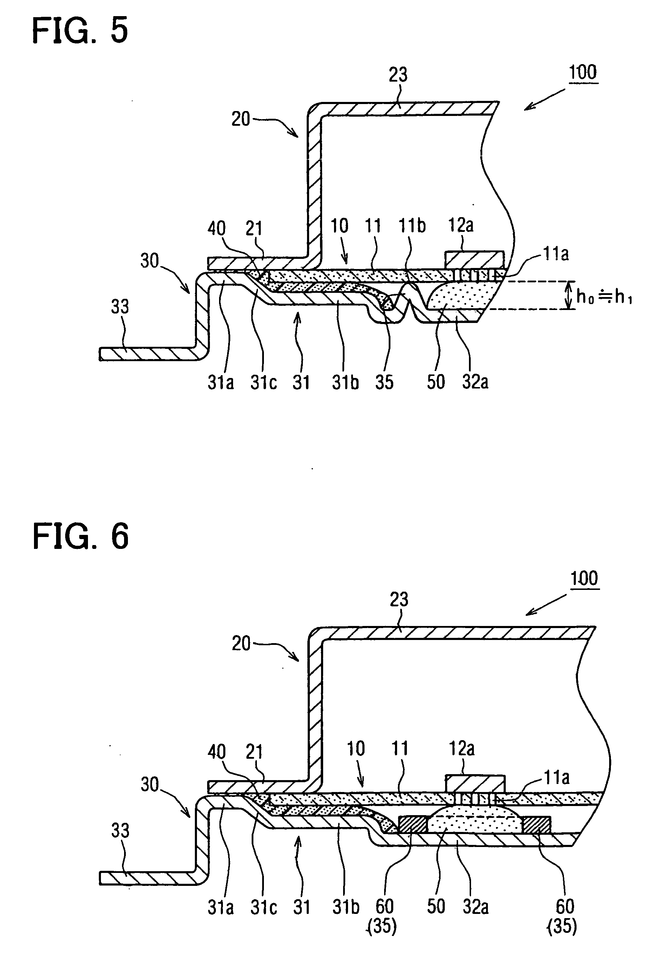

Next, a third embodiment of the present invention will be described with reference to FIG. 5.

As shown in FIG. 5, in an electronic device 100 according to the third embodiment, the height h1 of the projection portion 35 is set nearly equal to a clearance (distance) h₀ between an arrangement portion of the base member 30, where the thermally conductive material 50 is arranged, and the surface of the printed circuit board 11 opposed to the thermally conductive material 50. A contact portion 11 b where the printed circuit board 11 contacts the projection portion 35 is set in a region not to provide an electric connection function.

With this construction, it is also possible to have the same effects as described in the first and second embodiments. Moreover, the printed circuit board 11 is supported by the projection portion 35 made of a material that is harder to deform as compared with the printed circuit board 11. Therefore, it is possible to prevent a deformation (for example, a deformation caused by a temperature change) of the printed circuit board 11.

In the third embodiment, the projection portion 35 may be elongated in a straight line similarly to the first embodiment, or may be formed similarly to the examples of the second embodiment.

In the electronic device 100 of the construction according to this embodiment, because the contact portion 11 b where the printed circuit board 11 contacts the projection portion 35 is made in a region not to provide an electric connection function, the mounting area of the circuit substrate 10 is reduced due to this region. Thus, it is preferable to make the area of the projection portion 35 in the planar direction as small as possible. For example, it is recommended to combine the construction according to this embodiment with the straight projection portion 35 described in the first embodiment. In the third embodiment, the other parts of the electronic device 100 can be made similarly to the above-described embodiments.

### (Fourth Embodiment)

Next, a fourth embodiment of the present invention will be described with reference to FIG. 6.

In the electronic device 100 according to the above-described first to third embodiments, the projection portion 35 is constructed of a part of the case (base member 30). However, in the fourth embodiment, as in one example of FIG. 6, a partition part 60 different from the base member 30 is formed as the projection portion. In this example of FIG. 6, just as with the projection portion 35 described in the second embodiment, the partition part 60 made of aluminum is arranged in an annular shape along the outer peripheral end of an arrangement portion where the thermally conductive material 50 is arranged. Furthermore, the partition part 60 is fixed to a surface of the base member 30, thereby being provided with the same function as the projection portion 35 described above. That is, the partition part 60 is also a projecting portion projecting inside from a surface of the base member 30.

Also in the electronic device 100 according to this embodiment, it is possible to reduce manufacturing cost because press working is employed for the case member 20 and the base member 30, similarly to the first to third embodiments.

Moreover, a projection portion projecting from the surface of the base member 30 is formed by the partition part 60 between a portion of the case (e.g., base member 30) where the thermally conductive material 50 is arranged and a portion of the case (e.g., base member 30) where the sealing material 40 is arranged. Therefore, it is possible to secure sealing performance and heat radiation performance.

Further, in this embodiment, the projection portion is constructed as the partition part 60 separate from the case (e.g., base member 30). Therefore, the shape of the projection portion can be set freely as compared with a case where the projection portion 35 is constructed as a portion of the case (e.g., base member 30) by press working. That is, it is possible to easily increase the height h₁ of the projection portion and to easily decrease the width of the projection portion without constraints in press working.

Still further, as shown in FIG. 6, when the partition part 60 is made in an annular shape, it is possible to prevent the contact between the sealing material 40 and the thermally conductive material 50 with more reliability. Furthermore, it is possible to prevent the movement of the thermally conductive material 50 by the annular partition part 60. That is, even if vibrations and the like are applied to the thermally conductive material 50, it is possible to secure heat radiation of the heating element 12a. Moreover, the thermally conductive material 50 can be easily accurately positioned.

In the fourth embodiment, it is also possible to employ a straight partition part 60 corresponding to the straight projection portion 35 shown in the first embodiment. Moreover, it is also possible to make the height of the partition part 60 approximately equal to the clearance distance h₀ between the portion of the case (base member 30) where the thermally conductive material 50 is arranged and the surface of the printed circuit board 11 opposed to the thermally conductive material 50.

Up to this point, the preferred embodiments of the present invention have been described. However, the present invention is not limited to the above-mentioned embodiments, but the present invention may be implemented in various modifications within the scope of the appended claims.

For example, in the respective embodiments have been described examples in which the silicon gel (heat radiating gel) is used as the thermally conductive material 50. When a heat radiating grease is employed, however, it is also possible to produce the same effect as the heat radiating gel.

Furthermore, in the respective embodiments, the projection portion 35 or the partition part (e.g., annular partition part) 60 corresponding to the projection portion 35 is formed on the base member 30. When heat is radiated to the case member 20, however, it is recommended to form the projection portion 35 or the partition part (e.g., annular partition part) 60 corresponding to the projection portion 35 on the case member 20. Moreover, when heat is radiated to both sides of the case member 20 and the base member 30, it is recommended to form the projection portion 35 or the partition part 60 corresponding to the projection portion 35 on each of the case member 20 and the base member 30.

Furthermore, the shape of the projection portion 35 or the partition part 60 can be suitably changed only when the projection portion 35 or the partition part 60 can separate and partition the sealing material from the thermally conductive material 50.

Such changes and modifications are to be understood as being within the scope of the present invention as defined by the appended claims.

## Claims

1. An electronic device comprising:
a circuit substrate (10) having a printed circuit board (11), and an electronic component (12a) mounted on a peripheral portion of the printed circuit board (11);
a case for housing the circuit substrate (10) including a case member (20) and a base member (30),
a sealing material (40) interposed between the case member (20) and the base member (30) so as to form a waterproof space in which the circuit substrate (10) is housed;
a thermally conductive material (50) having flexibility, interposed in at least one of a space between the case (20, 30) and the electronic component (12a) and a space between the case (20, 30) and a back surface of a portion of the printed circuit board (11) where the electronic component (12a) is mounted; and
a projection portion (35, 60) provided in the case between a first portion (32a) where the thermally conductive material (50) is arranged and a second portion (31) where the sealing material (40) is arranged, wherein
the sealing material (40) is a flowing material before being hardened;
**characterized in that**
the projection portion (35, 60) is located within the waterproof space and
protrudes into the waterproof space to prevent the sealing material (40) before being hardened from flowing to and contacting the thermally conductive material (50) so as to separate the sealing material (40) and the thermally conductive material (50) from each other.

2. The electronic device according to claim 1, wherein:
at least one of the case member (20) and the base member (30) on a side where the thermally conductive material (50) is arranged with respect to the printed circuit board is formed by pressing; and
the projection portion (35) is integrally constructed as a part of the case by the pressing.

3. The electronic device according to claim 1, wherein the projection portion is a partition part (60) that is fixed to the case (20, 30) after being formed separately from the case (20, 30).

4. The electronic device according to claim 3, wherein at least one of the case member (20) and the base member (30) on a side where the thermally conductive material (50) is arranged with respect to the printed circuit board (11) is formed by pressing.

5. The electronic device according to any one of claims 1 - 4, wherein the projection portion (35, 60) is formed only between the first portion and the second portion, which are close and opposite to each other.

6. The electronic device according to any one of claims 1 - 4, wherein the projection portion (35, 60) is formed in an annular shape along at least a portion of an outer peripheral end of the first portion where the thermally conductive material is arranged.

7. The electronic device according to any one of claims 1 - 6, wherein the projection portion (35, 60) has a height that is set to prevent the projection portion (35, 60) from contacting a surface of the printed circuit board.

8. The electronic device according to any one of claims 1 - 6,
wherein the projection portion (35, 60) has a height that is set nearly equal to a clearance between the first portion where the thermally conductive material (50) is arranged and a surface of the printed circuit board opposed to the thermally conductive material (50), and
wherein the printed circuit board (11) has a region without providing an electric connection function, as a contact portion where the printed circuit board (11) contacts the projection portion (35, 60).

9. The electronic device according to any one of claims 1 - 8,
wherein the printed circuit board (11) is placed on the case member (20) or the base member (30) to form a clearance for sealing, between an end surface of the printed circuit board (11), and the case member (20) or the base member (30) opposed to the end surface, and
wherein the sealing material (40) is arranged in the clearance for sealing.

10. The electronic device according to claim 9, wherein the case member (20) or the bare member (30) has a
fixing portion (31a, 31c) for fixing the printed circuit board (11) and for forming the clearance for sealing between the case member (20) and the base member (30),
wherein the second portion (31) has a flat portion (31b) connecting with the fixing portion (31a, 31c) and arranged opposite to the printed circuit board (11), and the first portion (32a) is a bottom portion (32a) connecting with the flat portion (31 b) and having the projection portion (35, 60) formed thereon, and
wherein a distance between the bottom portion (32a) and the printed circuit board (11) is larger than a distance between the flat portion (31 b) and the printed circuit board (11).

11. The electronic device according to any one of claims 1 - 10, wherein the thermally conductive material (50) is made of heat radiating gel or heat radiating grease.

## Patentansprüche

1. Elektronische Vorrichtung, die aufweist:
ein Schaltungssubstrat (10), das eine Leiterplatte (11) und eine elektronische Komponente (12a), die an einem Umfangsabschnitt der Leiterplatte (11) montiert ist, aufweist;
ein Gehäuse zur Unterbringung des Schaltungssubstrats (10), das ein Gehäuseelement (20) und ein Basiselement (30) enthält;
ein Abdichtmaterial (40), das zwischen dem Gehäuseelement (20) und dem Basiselement (30) angeordnet ist, um einen wasserdichten Raum auszubilden, in dem das Schaltungssubstrat (10) untergebracht ist;
ein thermisch leitendes Material (50), das flexibel ist, in mindestens einem Raum aus einem Raum zwischen dem Gehäuse (20, 30) und der elektronischen Komponente (12a) und einem Raum zwischen dem Gehäuse (20, 30) und einer Rückfläche eines Abschnitts der Leiterplatte (11), bei dem die elektronische Komponente (12a) montiert ist, angeordnet ist; und
einen Vorstehungsabschnitt (35, 60), der in dem Gehäuse zwischen einem ersten Abschnitt (32a), bei dem das thermisch leitende Material (50) angeordnet ist, und einem zweiten Abschnitt (31), bei dem das Abdichtmaterial (40) angeordnet ist, vorgesehen ist, wobei
das Abdichtmaterial (40) vor seiner Härtung ein fließendes Material ist;
**dadurch gekennzeichnet, dass**
der Vorstehungsabschnitt (35, 60) innerhalb des wasserdichten Raums angeordnet ist und in den wasserdichten Raum vorsteht, um zu verhindern, dass das Abdichtmaterial (40) vor seiner Härtung zu dem thermisch leitenden Material (50) fließt und dieses kontaktiert, so dass das Abdichtmaterial (40) und das thermisch leitende Material (50) voneinander getrennt sind.

2. Elektronische Vorrichtung nach Anspruch 1, wobei
mindestens ein Element aus dem Gehäuseelement (20) und dem Basiselement (30) auf einer Seite, bei der das thermisch leitende Material (50) in Bezug auf die Leiterplatte angeordnet ist, mittels Pressen ausgebildet ist; und
der Vorstehungsabschnitt (35) mittels des Pressens einstückig als ein Teil des Gehäuses ausgebildet ist.

3. Elektronische Vorrichtung nach Anspruch 1, wobei der Vorstehungsabschnitt ein Trennteil (60) ist, das an dem Gehäuse (20, 30) nach seiner getrennten Ausbildung von dem Gehäuse (20, 30) fixiert ist.

4. Elektronische Vorrichtung nach Anspruch 3, wobei mindestens ein Element aus dem Gehäuseelement (20) und dem Basiselement (30) auf einer Seite, bei der das thermisch leitende Material (50) in Bezug auf die Leiterplatte (11) angeordnet ist, mittels Pressen ausgebildet ist.

5. Elektronische Vorrichtung nach einem der Ansprüche 1 bis 4, wobei der Vorstehungsabschnitt (35, 60) nur zwischen dem ersten Abschnitt und dem zweiten Abschnitt, die nahe beieinander und einander gegenüberliegend sind, ausgebildet ist.

6. Elektronische Vorrichtung nach einem der Ansprüche 1 bis 4, wobei der Vorstehungsabschnitt (35, 60) in einer ringförmigen Gestalt entlang mindestens eines Abschnitts eines Außenumfangendes des ersten Abschnitts, bei dem das thermisch leitende Material angeordnet ist, ausgebildet ist.

7. Elektronische Vorrichtung nach einem der Ansprüche 1 bis 6, wobei der Vorstehungsabschnitt (35, 60) eine Höhe aufweist, die derart festgelegt wird, dass verhindert wird, dass der Vorstehungsabschnitt (35, 60) eine Fläche der Leiterplatte kontaktiert.

8. Elektronische Vorrichtung nach einem der Ansprüche 1 bis 6,
wobei der Vorstehungsabschnitt (35, 60) eine Höhe aufweist, die auf nahezu gleich einem Leerraum zwischen dem ersten Abschnitt, bei dem das thermisch leitende Material (50) angeordnet ist, und einer Fläche der Leiterplatte, die dem thermisch leitenden Material (50) gegenüberliegt, festgelegt ist, und
wobei die Leiterplatte (11) einen Bereich als einen Kontaktabschnitt aufweist, bei dem die Leiterplatte (11) den Vorstehungsabschnitt (35, 60) kontaktiert, ohne eine elektrische Verbindungsfunktion bereitzustellen.

9. Elektronische Vorrichtung nach einem der Ansprüche 1 bis 8,
wobei die Leiterplatte (11) auf dem Gehäuseelement (20) oder dem Basiselement (30) angeordnet ist, um einen Leerraum zur Abdichtung zwischen einer Endfläche der Leiterplatte (11) und dem Gehäuseelement (20) oder dem Basiselement (30), das der Endfläche gegenüberliegt, auszubilden, und
wobei das Abdichtmaterial (40) zur Abdichtung in dem Leerraum angeordnet ist.

10. Elektronische Vorrichtung nach Anspruch 9,
wobei das Gehäuseelement (20) oder das Basiselement (30) einen Fixierungsabschnitt (31 a, 31 c) zum Fixieren der Leiterplatte (11) und zum Ausbilden des Leerraums zum Abdichten zwischen dem Gehäuseelement (20) und dem Basiselement (30) aufweist,
wobei der zweite Abschnitt (31) einen flachen Abschnitt (31 b) aufweist, der mit dem Fixierungsabschnitt (31 a, 31 c) verbunden und von gegenüber der Leiterplatte (11) angeordnet ist, und der erste Abschnitt (32a) ein Bodenabschnitt (32a) ist, der mit dem flachen Abschnitt (31 b) verbunden ist und den Vorstehungsabschnitt (35, 60) darauf ausgebildet aufweist, und
wobei ein Abstand zwischen dem Bodenabschnitt (32a) und der Leiterplatte (11) größer als ein Abstand zwischen dem flachen Abschnitt (31 b) und der Leiterplatte (11) ist.

11. Elektronische Vorrichtung nach einem der Ansprüche 1 bis 10, wobei das thermisch leitende Material (50) aus einem Wärmeabgabegel oder einem Wärmeabgabeschmiermittel besteht.

## Revendications

1. Dispositif électronique comprenant :
un substrat de circuit (10) présentant une carte de circuit imprimé (11), et un composant électronique (12a) monté sur une partie périphérique de la carte de circuit imprimé (11) ;
un boîtier pour loger le substrat de circuit (10) comprenant un élément de boîtier (20) et un élément de base (30),
un matériau d'étanchéité (40) intercalé entre l'élément de boîtier (20) et l'élément de base (30) de sorte à former un espace étanche à l'eau dans lequel est logé le substrat de circuit (10) ;
un matériau thermoconducteur (50) présentant une certaine flexibilité, intercalé dans au moins un d'un espace entre le boîtier (20, 30) et le composant électronique (12a) et d'un espace entre le boîtier (20, 30) et une surface arrière d'une partie de la carte de circuit imprimé (11) où le composant électronique (12a) est monté ; et
une partie en saillie (35, 60) prévue dans le boîtier entre une première partie (32a) où est agencé le matériau thermoconducteur (50) et une seconde partie (31) où est agencé le matériau d'étanchéité (40), dans lequel
le matériau d'étanchéité (40) est un matériau fluide avant d'être durci ;
**caractérisé en ce que**
la partie en saillie (35, 60) se trouve à l'intérieur de l'espace étanche à l'eau et fait saillie dans l'espace étanche à l'eau pour empêcher que le matériau d'étanchéité (40) avant d'être durci ne s'écoule vers le matériau thermoconducteur (50) et entre en contact avec celui-ci de sorte à séparer le matériau d'étanchéité (40) et le matériau thermoconducteur (50) l'un de l'autre.

2. Dispositif électronique selon la revendication 1, dans lequel :
au moins un de l'élément de boîtier (20) et de l'élément de base (30) sur un côté où le matériau thermoconducteur (50) est agencé par rapport à la carte de circuit imprimé est formé par pression ; et
la partie en saillie (35) est construite d'un seul tenant avec le boîtier par la pression.

3. Dispositif électronique selon la revendication 1, dans lequel la partie en saillie est une partie de séparation (60) qui est fixée au boîtier (20, 30) après être formée séparément du boîtier (20, 30).

4. Dispositif électronique selon la revendication 3, dans lequel au moins un de l'élément de boîtier (20) et de l'élément de base (30) sur un côté où le matériau thermoconducteur (50) est agencé par rapport à la carte de circuit imprimé (11) est formé par pression.

5. Dispositif électronique selon l'une quelconque des revendications 1 à 4, dans lequel la partie en saillie (35, 60) est formée uniquement entre la première partie et la seconde partie, qui sont proches et opposées l'une par rapport à l'autre.

6. Dispositif électronique selon l'une quelconque des revendications 1 à 4, dans lequel la partie en saillie (35, 60) est formée selon une forme annulaire le long d'au moins une partie d'une extrémité périphérique externe de la première partie où est agencé le matériau thermoconducteur.

7. Dispositif électronique selon l'une quelconque des revendications 1 à 6, dans lequel la partie en saillie (35, 60) a une hauteur qui est définie pour empêcher que la partie en saillie (35, 60) n'entre en contact avec une surface de la carte de circuit imprimé.

8. Dispositif électronique selon l'une quelconque des revendications 1 à 6,
dans lequel la partie en saillie (35, 60) a une hauteur qui est définie à une valeur presque égale à un espacement entre la première partie où est agencé le matériau thermoconducteur (50) et une surface de la carte de circuit imprimé opposée au matériau thermoconducteur (50), et
dans lequel la carte de circuit imprimé (11) présente une région n'ayant pas de fonction de connexion électrique, en tant que partie de contact où la carte de circuit imprimé (11) entre en contact avec la partie de projection (35, 60).

9. Dispositif électronique selon l'une quelconque des revendications 1 à 8,
dans lequel la carte de circuit imprimé (11) est placée sur l'élément de boîtier (20) ou l'élément de base (30) pour former un espacement d'étanchéité, entre une surface d'extrémité de la carte de circuit imprimé (11), et l'élément de boîtier (20) ou l'élément de base (30) opposés à la surface d'extrémité, et
dans lequel le matériau d'étanchéité (40) est agencé dans l'espacement d'étanchéité.

10. Dispositif électronique selon la revendication 9,
dans lequel l'élément de boîtier (20) ou l'élément de base (30) possède une partie de fixation (31a, 31c) pour fixer la carte de circuit imprimé (11) et pour former l'espacement d'étanchéité entre l'élément de boîtier (20) et l'élément de base (30),
dans lequel la seconde partie (31) possède une partie plane (31b) en connexion avec la partie de fixation (31 a, 31 c) et agencée à l'opposé de la carte de circuit imprimé (11), et la première partie (32a) est une partie inférieure (32a) en connexion avec la partie plane (31b) et ayant la partie en saillie (35, 60) formée sur celle-ci, et
dans lequel une distance entre la partie inférieure (32a) et la carte de circuit imprimé (11) est plus grande qu'une distance entre la partie plane (31b) et la carte de circuit imprimé (11).

11. Dispositif électronique selon l'une quelconque des revendications 1 à 10, dans lequel le matériau thermoconducteur (50) est constitué de gel à rayonnement thermique ou de graisse à rayonnement thermique.
